# EUROPEAN PATENT APPLICATION

(11) **EP 2 722 678 A1**
(43) Date of publication of application: **23.04.2014**
(21) Application number: 12007202.0
(22) Date of filing: 18.10.2012
(51) Int. Cl.: G01R 15/14

(54) **Current and/or voltage sensing device for integrative use**

(71) Applicant: ABB Technology AG, 8050 Zürich (CH)
(72) Inventor: Javora, Radek, 624 00 Brno (CZ); Sevcik, Bretislav, 79827 Nemcice nad Hanou, (CZ); Podzemny, Jaromir, 621 00 Brno (CZ)
(74) Representative: Schmidt, Karl Michael

(57) **Abstract**

Current and/or voltage sensing device (1) for integrative use in electric energy distribution systems, with a current sensor (4) and/or an voltage sensor (5, 6). In order to realize optimal compactness and low weight, in order to simplify the installation, and to enable retrofit installation, that the voltage sensor and/or the current sensor is/are integrated in an insulating housing (2), which is designed as at least partly toroid body, surrounding a primary conductor (3) in the ready installed position of the sensing device, by which current and/or electrical potential of the primary conductor will be measured.

## Description

Current and/or voltage sensing device for integrative use in electric energy distribution systems, with a current sensor and/or an voltage sensor, according to the preamble of claim 1.

Current and voltage measurement in medium voltage (MV) switchgears operating in secondary distribution is usually included during production of such switchgears. Switchgear design needs to be done in such a way, that enables location and placement of current and/or voltage transformers inside of said switchgear. Size and weight of these instrument transformers is usually something, that drives the placement and location of other devices that are also within that switchgear.

Low-power stand-alone sensing devices or Electronic instrument transformers are also being used in factory-build switchgears and they achieve much smaller size and weight comparing to conventional instrument transformers or sensing devices.

In case when one wants to add current and/or voltage sensing devices into each phase of existing switchgear, it might be impossible to do that due to limited space between incomming or outgoing cable connection and circuit breaker, switch or disconnector. This is especially valid for conventional instrument transformers using iron core, which occupy significant space that might not be available in existing switchgear without some modification of its design. If switchgear design is significantly modified, new testing might be required in order to assure propper dielectric and/or temperature and/or current withstand or achieve required safety, accuracy and EMC performance.

So the object of the invention is, to realize optimal compactness and low weight, in order to simplify the installation, and to enable retrofit installation. All these advantageous should be resulted in the purpose of especially in medium voltage switchgears.

So this is solved by the invention, that the voltage sensor and/or the current sensor is/are integrated in an insulating housing, which is designed as a toroid body, surrounding a primary conductor in the ready installed position of the sensing device, by which current and/or electrical potential of the primary conductor will be measured. This is compact, weight reduced and the compactness is in such a way, that a retrofit installation even in medium voltage switchgears is simply possible.

Therefore in a furthermore advantageous embodiment, the sensing device is used in a medium voltage switchgear housing in such a way, that also in case of retrofit installation, no additional fixation means or constructive changes are need.

Concerning to that purpose, a further embodiment is given by that in use in medium voltage switchgears, the sensing device is placed between the bushing or any other fixed part of the switchgear and the connected cable.

In sense of reaching the desired compactness it is advantageous, that the current sensor is based on a Rogowski coil arrangement, by which the Rogowski coil is arranged in the torid housing around the primary conductor.

A further advantageous embodiment is, that the voltage sensor is a concentric arrangement in the toroid housing in that way, that an inner, that means near to the primary conductor placed first ring band electrode is concentrically surrounded by an outer ring band electrode as a shielding electrode, and that the electrical capacity between both electrodes and between inner electrode and the primary conductor are used for voltage determination.

A first advantageous embodiment concerning the placement of the sensor elements is, that the current sensor and the voltage sensor are implemented both in one common torid sensor housing in that way, that the current sensor coil is arranged beneath the voltage sensor electrodes

A further advantageous alternative to that is, that the current sensor and the voltage sensor are implemented both in one common torid sensor housing in that way, that the current sensor coil is arranged concentric to the voltage sensor electrodes, where current sensor is located in bigger distance from primary conductor then voltage sensor.

Another advantageous alternative is, that the current sensor and the voltage sensor are implemented both in one common toroid sensor housing in that way, that the current sensor coil or its housing or shielding is serving as the inner electrode of voltage sensor and is positioned concentric to the voltage sensor outer electrode, where outer electrode of voltage sensor is located in bigger distance from primary conductor then current sensor. In some cases, the outer electrode of voltage sensor might even not to be used to achieve required measurements.

In a final advantageous embodiment, the voltage sensor is a resistive divider, whiches current path is oriented perpendicular to the long axis of the primary conductor.

The invention is shown in the figures and described as follows.
Fig. 1: Small sized combined current/voltage sensing device
Fig. 2: Small sized combined current/voltage sensing device with reduced height
Fig. 3: Small sized combined current/voltage sensing device with optimized construction
Fig. 4: Small sized combined current/voltage sensing device with reduced height
Fig. 5: Small sized combined current/voltage sensing device with resistive voltage divider
Fig. 6: Small sized combined current/voltage sensing device with combined sensing parts
Fig. 7: Possible location of small combined sensing device

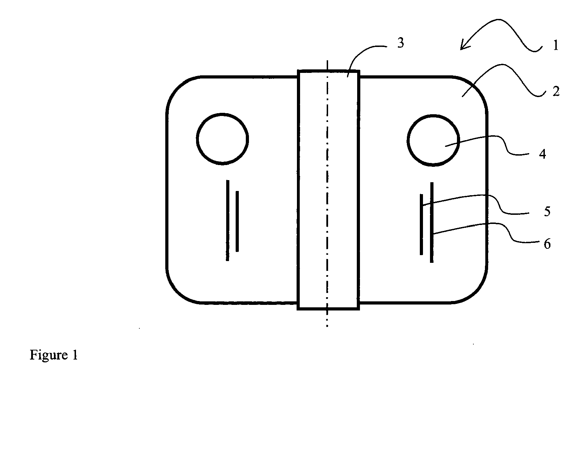

This invention proposes the use of small combined sensing device, that could be used both for factory installations as well as for easy retrofit of existing air-insulated switchgears without the need to significantly modify switchgear design, add additional fixation parts or anyhow interfer into existing construction of the switchgear. Current/voltage sensing device considers the use of current/voltage low-power stand-alone sensing technologies that do not contain any ferromagnetic core, nevertheless, the use of ferromagnetic cores could be also possible, when keeping small size of the elements. Current sensing device, in one preferred embodiment, considers the use of Rogowski coil technology, that enables the use of one single device for the wide range of measured currents and that enables to significantly reduce size of current sensing element. As such current sensing device does not contain any ferromagnetic core, it will be very light-weighted. Voltage sensing device could utilize either capacitive and/or resistive voltage divider technology. This technology also enables significant size and weight reduction, still achieving very good sensing accuracy. As both current and voltage sensing technologies enables creation of very small devices, it is easily possible to combine them into one single device. This possibility is utilized in proposed construction of small sized combined current/voltage sensing device. Such device consists of current and voltage sensing part as shown in Fig. 1.

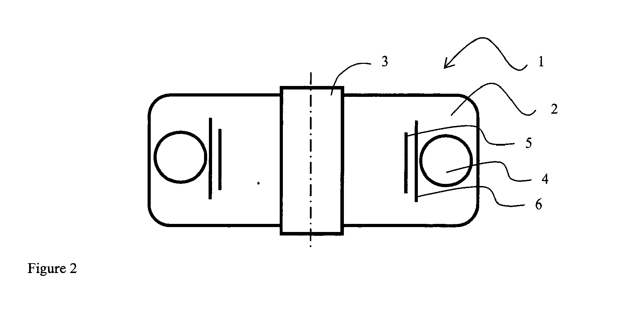

Combined sensing device 1 consists of insulating material 2, that provides sufficient dielectric strength, depending on the voltage level applied on primary conductor 3. Current sensing part 4 senses magnetic field that is proportional to the current flowing through the primary conductor 3. Voltage sensing part consists of primary capacitance created between primary conductor 3 and capacitive electrode 5 and secondary capacitance created between capacitive electrode 5 and shielding electrode 6. Shielding electrode 6 protect capacitive electrode 5 from external electric fields, thus shielding from external disturbances. In case division ratio of capacitances created between primary conductor 3, capacitive electrode 5 and shielding electrode 6 is not sufficient to create required ratio, external capacitors could be electrically connected in parallel to the output of such voltage divider to tune the divider ratio to required level. There might be different configurations of current and voltage sensing parts within the device 1.
Either as shown in Fig. 1, or as shown in Fig. 2.

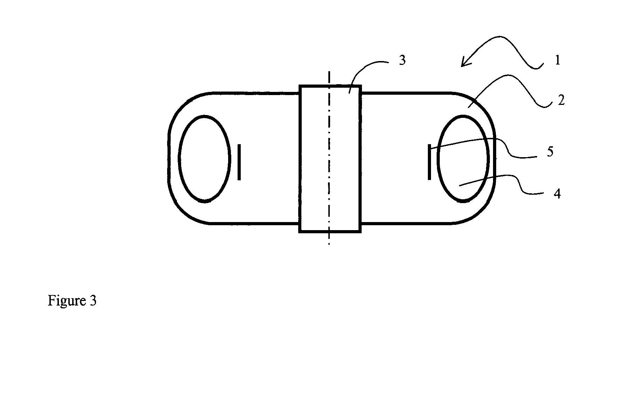

Depending on construction and size of current sensing device, the shielding electrode 6 does not need to be used in case the current sensing part 4 has a shape that is capable of covering the capacitive electrode 5 from size point of view and has its surface at least partly on ground potential. See example of such configuration in Fig. 3.

Due to a very small size that can be achieved, also additional electrode for voltage indication could be included in any of the above described devices.
Small size could be easily achieved by using low-power technologies, but conventional current transformer could be utilized for current measurement as well. In either case, it has to be ensured that dielectric withstand of the insulation material 2 is sufficient to withstand all dielectric tests related to the voltage level where this device is applied.

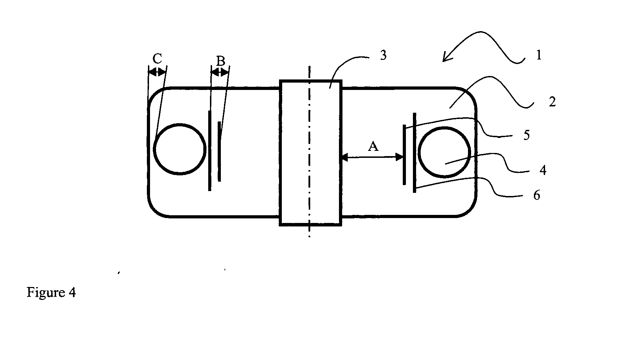

Referring to Fig. 4, it has to be assured that distance A between primary conductor 3 and capacitive electrode is sufficient to withstand required voltage elevels. Distance B between capacitive electrode 5 and shielded electrode 6 is usually very small (1 mm is usually sufficient), as the difference of potentials between both electrodes is not huge. Distance C of the current sensing element 4 from the surface of combined device 1 is not required to be more then 0 mm, nevertheless, it is a good practice to have it at least 1 mm to properly cover current sensing element from external environment, mechanical damage or from high electric stresses depending on surrounding environment or devices.

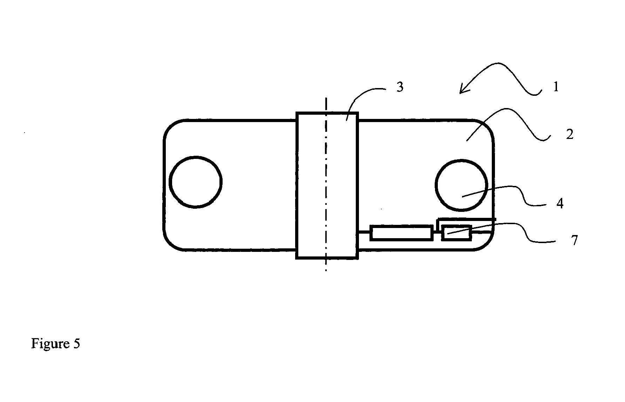

Said combined device 1 can also contain resistive voltage divider instead of capacitive one. In order to achieve a small size required, the resistive divider 7 can be placed e.g. according to Fig. 5.

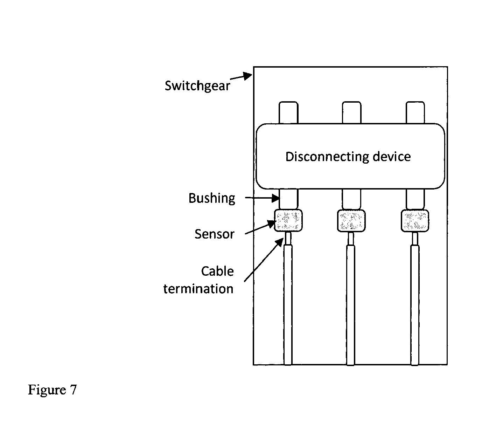

Sensing parts could be combined and/or shared within current and voltage sensing parts. Fig. 7 shows possible construction, where the current sensor is used in the same time also as inner (capacitive) electrode of the voltage sensor. This solution avoid the need for additional electrode, thus reducing costs and complexity of such sensing device. Easiest construction is to use conductive or semi-conductive shielding of current sensor as capacitive electrode.

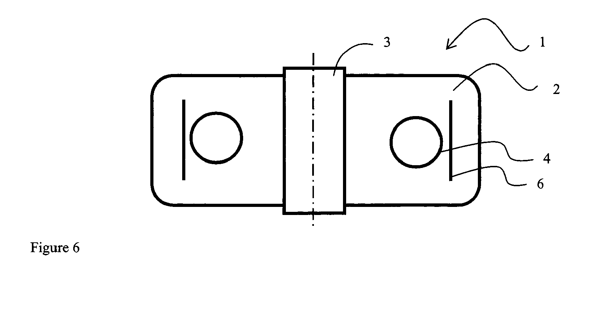

In any of the constructions described in Fig. 1 to Fig.6 above, the outer (shielding) electrode of voltage sensor might not be used, depending on surrounding environment, external influences or sensing accuracy required.

Any of the constructions described in Fig. 1 to Fig. 6 could be applied for air-insulated or gas-insulated switchgears. Any of the constructions described in Fig. 1 to Fig. 6 can have a primary conductor cast in the device 1 or there could be hole inside of the device 1 through which the primary conductor could be inserted.

Biggest advantage of the proposed solution is for applications where incomming or outgoing cables are connected in cable compartment of the air-insulated switchgears. As it is usually possible to move connected cables few centimeters down, the proposed combisensor 1 could be placed between the original connection point on the switchgear and the cable, see possible location shown in Fig. 7.

Due to the light-weight of the combined sensing device, there is no necessity to improve mechanical strength of the connected parts in order to withstand all mechanical forces that might occur during operation or testing of the switchgear.

### Position numbers

- 1: combined sensing device
- 2: insulating material
- 3: primary conductor
- 4: current sensor part
- 5: capacitive electrode
- 6: shielding electrode
- 7: resistive divider

## Claims

1. Current and/or voltage sensing device for integrative use in electric energy distribution systems, with a current sensor and/or an voltage sensor,
**characterized in**
**that** the voltage sensor and/or the current sensor is/are integrated in an insulating housing, which is designed as at least partly toroid body, surrounding a primary conductor in the ready installed position of the sensing device, by which current and/or electrical potential of the primary conductor will be measured.

2. Current and/or voltage sensing device according to claim 1,
**characterized in**
**that** the sensing device is used in a medium voltage switchgear housing in such a way, that also in case of retrofit installation, no additional fixation means or constructive changes are need.

3. Current and/or voltage sensing device according to claim 2,
**characterized in**
**that** in use in medium voltage switchgears, the sensing device is placed between the bushing or any other fixed part of the switchgear and the connected cable.

4. Current and/or voltage sensing device according to one of the aforesaid claims,
**characterized in**
**that** the current sensor is based on a Rogowski coil arrangement, by which the Rogowski coil is arranged in at least partly toroid housing around the primary conductor.

5. Current and/or voltage sensing device according to one of the aforesaid claims,
**characterized in**
**that** the current sensor is based on a current transformer technology, by which the current transformer is arranged in at least partly toroid housing around the primary conductor.

6. Current and/or voltage sensing device according to one of the aforesaid claims,
**characterized in**
**that** the voltage sensor is a concentric arrangement in at least partly toroid housing in that way, that an inner, that means near to the primary conductor placed first ring band electrode is concentrically surrounded by an outer ring band electrode as a shielding electrode, and that the electrical capacity between both electrodes is used for voltage determination.

7. Current and/or voltage sensing device according to one of the aforesaid claims 1-5,
**characterized in**
**that** a current sensor and a voltage sensor are implemented both in one common toroid sensor housing in that way, that the current sensor coil is arranged next to the voltage sensor electrodes.

8. Current and/or voltage sensing device according to one of the aforesaid claims 1-5,
**characterized in**
**that** a current sensor and a voltage sensor are implemented both in one common torid sensor housing in that way, that the current sensor coil is arranged concentric to the voltage sensor electrodes.

9. Current and/or voltage sensing device according to one of the aforesaid claims 1-8,
**characterized in**
**that** a current sensor or its shielding or its housing is used in the same time also as capacitive electrode of the voltage sensor.

10. Current and/or voltage sensing device according to one of the aforesaid claims 1-5,
**characterized in**
**that** the voltage sensor is a resistive divider, whiches one end is connected to the primary conductor and the other end to the grounding potential.

11. Current and/or voltage sensing device according to claim 1,
**characterized in**
**that** the insulating housing body can have a shape different from toroid.
